# EUROPEAN PATENT APPLICATION

(11) **EP 4 729 951 A1**
(43) Date of publication of application: **22.04.2026**
(21) Application number: 24306692.5
(22) Date of filing: 15.10.2024
(51) Int. Cl.: G01R 19/165, G01R 31/28, G01R 31/3187, G06F 1/28, G01R 31/317

(54) **SYSTEM AND METHOD TO ACCELERATE POWER SAFETY MANAGEMENT START-UP SEQUENCE**

(71) Applicant: NXP USA, Inc., Austin TX 78735 (US)
(72) Inventor: Founaud, Guillaume Jean, 31023 Toulouse (FR); Turpin, Pierre, 31023 Toulouse (FR); Bernon, Valerie, 31023 Toulouse (FR)
(74) Representative: Krott, Michel

(57) **Abstract**

To help reduce the amount of time before a safety power management integrated circuit (PMIC) releases a processing system from a safety state, the safety PMIC includes a first digital circuitry that first configures a voltage threshold comparator and then enables a voltage regulator to provide power to the rest of the PMIC. Additionally, concurrently with the rest of the PMIC powering on, the safety PMIC includes a second digital circuitry that is distinct from the first digital circuitry and that performs a logic built-in self-test (LBIST) for a safety logic circuitry configured to monitor the voltage threshold comparator.

## Description

### BACKGROUND

Certain systems, such as those implemented in automobiles, include processors configured to provide various functions, for example, navigation, audio, and safety functions. To power these processors, such systems include voltage regulators that each provide a respective voltage to one or more corresponding processors. Further, the systems implement power-management integrated circuits (PMICs) that monitor the voltage output by corresponding voltage regulators to help prevent or mitigate overvoltage events caused by the voltage regulators. Additionally, to help ensure the correct configuration and operation of the PMICs, the PMICs are configured to perform one or more self-tests before the voltage regulators are enabled to provide voltages to respective processors. Only after performing these self-tests, the PMICs are each configured to enable a respective voltage regulator such that the voltage regulator provides a voltage to a corresponding processor.

### SUMMARY

In accordance with a first aspect of the present disclosure, an integrated circuit (IC) is provided, comprising: a first digital circuitry configured to: configure a voltage threshold comparator based on configuration data; and based on the voltage threshold comparator being configured, enable a voltage regulator such that the voltage regulator outputs a voltage and at least a portion of the IC begins powering on; and a second digital circuitry separate from the first digital circuitry and configured to: concurrently with the at least a portion of the IC powering on, perform a logic built-in self-test (LBIST) for a third digital circuitry configured to monitor the voltage threshold comparator.

In one or more embodiments, the third digital circuitry is configured to: after completion of the LBIST, validate the configuration data based on one or more data error protection operations.

In one or more embodiments, the first digital circuitry is configured to: before configuring the voltage threshold comparator based on the configuration data, validate the configuration data based on a data error protection operation different from the one or more data error protection operations.

In one or more embodiments, the third digital circuitry is configured to: perform an analog built-in self-test (ABIST) to determine whether the voltage threshold comparator includes one or more latent faults.

In one or more embodiments, the third digital circuitry is configured to: release at least a portion of a system including the IC from a safety state based on completion of the ABIST.

In one or more embodiments, the IC further comprises: a multiplexer configured to: based on the voltage threshold comparator being configured by the first digital circuitry, provide an output of the voltage threshold comparator to the voltage regulator; and based on the ABIST being completed, provide a safety signal from the third digital circuitry to the voltage regulator.

In one or more embodiments, the third digital circuitry is configured to: in response to the voltage threshold comparator detecting an overvoltage event, disable, via the safety signal, the voltage regulator such that the voltage regulator does not provide the voltage.

In one or more embodiments, the third digital circuitry is configured to: based on the LBIST being completed, load the configuration data from the first digital circuitry.

In accordance with a second aspect of the present disclosure, a method is conceived, comprising: configuring, by a first digital circuitry of an integrated circuit (IC), a voltage threshold comparator based on configuration data; based on the voltage threshold comparator being configured, enabling a voltage regulator such that the voltage regulator outputs a voltage and at least a portion of the IC begins powering on; and concurrently with the at least a portion of the IC powering on, performing a logic built-in self-test (LBIST) for a second digital circuitry configured to monitor the voltage threshold comparator.

In one or more embodiments, the method further comprises: after the LBIST, validating, by the second digital circuitry, the configuration data based on one or more data error protection operations.

In one or more embodiments, the method further comprises: before configuring the voltage threshold comparator based on the configuration data, validating, by the first digital circuitry, the configuration data based on a data error protection operation different from the one or more data error protection operations.

In one or more embodiments, the method further comprises: performing, by the second digital circuitry, an analog built-in self-test (ABIST) to determine whether the voltage threshold comparator includes one or more latent faults.

In one or more embodiments, the method further comprises: releasing, by the second digital circuitry, at least a portion of a system including the IC from a safety state based on a completion of the ABIST.

In one or more embodiments, the method further comprises: based on the voltage threshold comparator being configured by the first digital circuitry, providing an output of the voltage threshold comparator to the voltage regulator; and based on the ABIST being completed, providing a safety signal from the second digital circuitry to the voltage regulator.

In one or more embodiments, the method further comprises: in response to the voltage threshold comparator detecting an overvoltage event, disabling, via the safety signal, the voltage regulator such that the voltage regulator does not provide the voltage.

In one or more embodiments, the method further comprises: based on the LBIST being completed, loading the configuration data from the first digital circuitry.

In accordance with a third aspect of the present disclosure, an integrated circuit (IC) is provided, comprising: a voltage threshold comparator configured to monitor a voltage output by a voltage regulator; a first digital circuitry configured to: load configuration data from a memory; and based on validating the configuration data, enable the voltage regulator such that the voltage regulator outputs the voltage and the IC begins powering up; and a second digital circuitry separate from the first digital circuitry and configured to, concurrently with the IC powering up, perform a logic built-in self-test (LBIST) for a third digital circuitry configured to monitor the voltage threshold comparator.

In one or more embodiments, the first digital circuitry is configured to: before enabling the voltage regulator, configure the voltage threshold comparator based on the configuration data.

In one or more embodiments, the third digital circuitry is configured to: based on the LBIST being completed, perform an analog built-in self-test (ABIST) to determine one or more latent faults in the voltage threshold comparator.

In one or more embodiments, the third digital circuitry is configured to: release at least a portion of a system including the IC from a safety state based on the ABIST being completed.

### BRIEF DESCRIPTION OF THE DRAWINGS

The present disclosure may be better understood, and its numerous features and advantages are made apparent to those skilled in the art by referencing the accompanying drawings. The use of the same reference symbols in different drawings indicates similar or identical items.
FIG. 1 is a block diagram of a safety power management integrated circuit (PMIC) configured to provide voltage monitoring functions, in accordance with some embodiments.
FIG. 2 is a block diagram of a safety PMIC architecture configured to perform at least a portion of a logic built-in self-test (LBIST) concurrently with powering up at least a portion of the safety PMIC, in accordance with some embodiments.
FIG. 3 is a timing diagram of example safety start-up sequences each including LBISTs and ABISTs, in accordance with some embodiments.
FIG. 4 is a flow diagram of an example method that includes performing at least a portion of an LBIST concurrently with powering up at least a portion of a safety PMIC, in accordance with some embodiments.

### DETAILED DESCRIPTION

Systems and techniques disclosed herein include a safety power management integrated circuit (PMIC) configured to test the safety and robustness of power supplies implemented, for example, in automotive systems, electric vehicle systems, aviation systems, and the like. For example, within such systems, the safety PMIC includes one or more voltage regulators configured to provide a predetermined voltage (e.g., range of voltages) based on the power supplies to one or more processors configured to perform one or more functions of the system such as infotainment functions (e.g., navigation functions, calling functions, music streaming functions), climate functions (e.g., electric pump functions, HVAC functions), vehicle functions (e.g., safety functions, transmission functions, power steering functions), power functions (e.g., battery management functions, power inverter functions), radar systems, vision systems, and the like. To help protect against overvoltage events caused by a voltage regulator, the safety PMIC further includes a voltage threshold comparator connected to the voltage regulator such that the voltage threshold comparator provides an output based on a comparison of a voltage output by the voltage regulator and a voltage threshold (e.g., reference voltage). As an example, based on a voltage output by the voltage regulator exceeding the voltage threshold (e.g., an overvolt event), the voltage threshold comparator outputs a signal at a first value as defined by one or more supply voltages indicating that an overvolt event has occurred. In response to this signal, the safety PMIC then disables the voltage regulator such that the voltage regulator does not provide a voltage to the processors. To configure the voltage threshold comparator, the PMIC includes or is otherwise connected to a memory, such as a non-volatile storage, that stores safety configuration data indicating one or more parameters for the voltage threshold comparator such as a reference voltage to be supplied, a first supply voltage to be supplied, a second supply voltage to be supplied, impedance values, or any combination thereof. Based on a system beginning to power on, the PMIC configures the voltage threshold comparator based on the safety configuration data stored in the memory. For example, the PMIC supplies one or more voltages to the voltage threshold comparator, adjusts one or more impedances of the voltage threshold comparator, or both as indicated by the safety configuration data.

Additionally, to help protect against latent faults in the safety PMIC and to help ensure the safety PMIC is operating reliably, the safety PMIC is configured to perform one or more built-in self-tests before a corresponding voltage regulator is enabled to provide a voltage to one or more processors. For example, in response to a system beginning to power up, the safety PMIC first places at least a portion of the system (e.g., a processor) in a safety state. A digital circuitry of the safety PMIC then performs a logic built-in self-test (LBIST) to test a safety circuitry (e.g., safety logic circuitry) of the safety PMIC under certain conditions. That is, the digital circuitry performs an LBIST to detect latent faults in the safety circuitry that arise under certain conditions. For example, during the LBIST, the digital circuitry tests one or more operations associated with the safety circuitry (e.g., data error protection operations), components of the safety circuitry (e.g., storage, logic gates), or both for one or more latent faults under certain conditions. After the digital circuitry determines, based on the LBIST, that there are no latent faults in the safety circuitry, the safety circuitry loads the safety configuration data (e.g., is configured to load configuration data) from the memory and performs one or more error correction codes (ECCs), cyclic redundancy checks (CRCs), or both to determine whether the safety configuration data is valid. Based on the safety configuration data being valid, the safety circuitry begins to provide signals to the voltage threshold comparator based on the validated safety configuration data. Further, based on the safety configuration data being valid, the safety circuitry enables the voltage regulator to output a voltage such that at least a portion of the safety PMIC begins to power up. For example, the voltage regulator outputs a voltage such that one or more microcontrollers, capacitors, memories, or any combination thereof of the safety PMIC begin to power up.

After the safety PMIC has been powered up, the safety circuitry tests the robustness of the voltage threshold comparator. For example, the safety circuitry performs an analog built-in self-test (ABIST) that includes testing the output of the voltage threshold comparator under certain conditions. That is, the safety circuitry performs an ABIST to detect latent faults in the voltage threshold comparator that arise under certain conditions. For example, during the ABIST, the safety circuitry places the voltage regulator, voltage threshold comparator, or both under certain conditions that induce certain events, such as overvoltage events, and monitors the output of the voltage threshold comparator to determine if such events were detected. After determining that there are no latent faults in the voltage threshold comparator, the safety circuitry indicates that the voltage regulator is available for normal operation by, for example, generating a signal indicating that the safety state for the portion of the system is to be released.

However, first waiting for the digital circuitry to complete the LBIST before powering up the safety PMIC and performing the ABIST increases the amount of time at least a portion of the system remains in a safety state. In other words, first waiting for the digital circuitry to complete the LBIST before powering up the PMIC and performing the ABIST increases the amount of time before the portion of the system can begin normal operation. As such, systems and techniques disclosed herein are directed to a safety PMIC configured to concurrently perform at least a portion of an LBIST while powering up at least a portion of the safety PMIC. For example, the safety PMIC includes a first digital circuitry (e.g., safety configuration circuitry) that first validates the safety configuration data and a second digital circuitry (e.g., LBIST circuitry) separate from the first digital circuitry that performs the LBIST. Based on the system beginning to power on, the safety PMIC places at least a portion of the system in a safety state. Further, based on the system beginning to power on, the first digital circuitry retrieves the safety configuration data from the memory and performs one or more CRCs, ECCs, or both to validate the safety configuration data. The first digital circuitry then provides signals to the voltage threshold comparator based on the validated safety configuration data. Additionally, the safety circuitry enables the voltage regulator to provide a voltage such that at least a portion of the safety PMIC begins to power up. Concurrently with the portion of safety PMIC powering up, the second digital circuitry performs an LBIST to determine whether the safety circuitry includes one or more latent faults. After the second digital circuitry determines that the safety circuitry does not include any latent faults, the safety circuitry loads the safety configuration data from the first digital circuitry, validates the safety configuration data, and begins normal operation.

Further, after the safety PMIC has powered up and the safety circuitry begins normal operation (e.g., after the safety circuitry has validated the safety configuration data), the safety circuitry performs the ABIST. Based on the ABIST indicating that the voltage threshold comparator has no latent faults, the safety circuitry releases the portion of the system from the safety state and the portion of the system begins normal operation. Because the first digital circuitry enables the voltage regulator before the second digital circuitry performs the LBIST, the second digital circuitry is enabled to perform the LBIST concurrently with at least a portion of the safety PMIC powering up. Performing the LBIST concurrently with at least a portion of the safety PMIC powering up in this way helps reduce the amount of time before the safety circuitry is able to release the safety state for the portion of the system, allowing the system to begin normal operation more quickly.

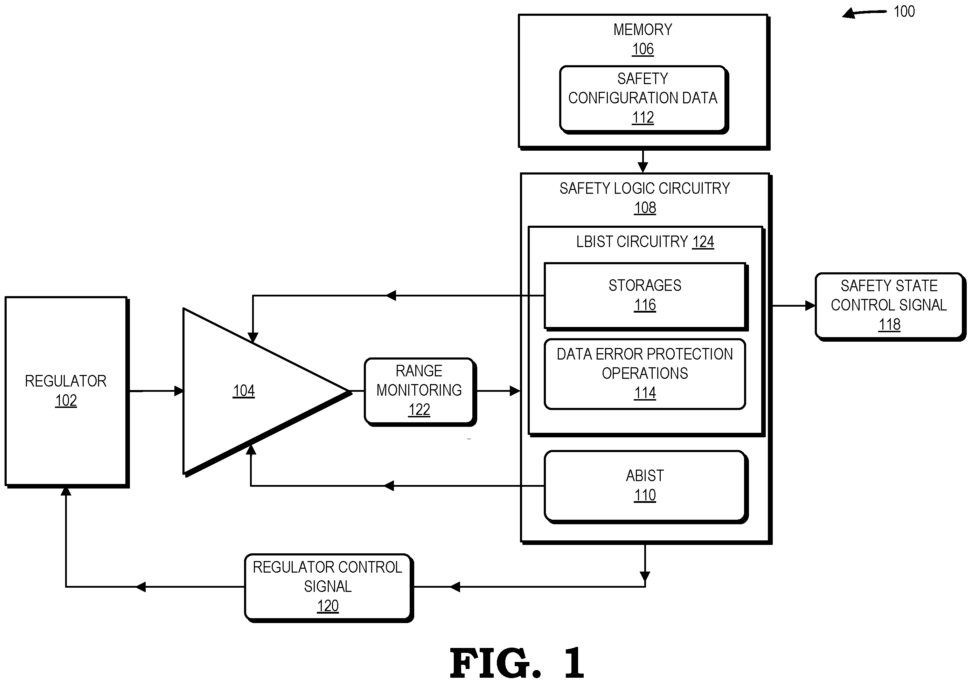

Referring now to FIG. 1, a safety PMIC 100 configured to provide voltage monitoring functions is presented, in accordance with some embodiments. In embodiments, safety PMIC 100 is implemented within one or more automotive systems, electric vehicle systems, aviation systems, and the like and includes voltage regulator 102. This voltage regulator 102, for example, includes an analog voltage regulator configured to provide a voltage to at least a portion of the system, such as one or more processors, that perform one or more functions for the system such as infotainment functions (e.g., navigation functions, calling functions, music streaming functions), climate functions (e.g., electric pump functions, HVAC functions), vehicle functions (e.g., safety functions, transmission functions, power steering functions), power functions (e.g., battery management functions, power inverter functions), radar systems, vision systems, or any combination thereof. To help prevent or mitigate overvoltage events caused by voltage regulator 102, safety PMIC 100 includes voltage threshold comparator 104 that, for example, includes an analog voltage threshold comparator configured to perform range monitoring 122. That is, voltage threshold comparator 104 is configured to monitor the voltage output by voltage regulator 102. Such range monitoring 122, for example, includes voltage threshold comparator 104 comparing the voltage output by voltage regulator 102 to a predetermined threshold voltage so as to detect one or more overvoltage events. As an example, based on the voltage output by voltage regulator 102 exceeding a reference voltage supplied to voltage threshold comparator 104, voltage threshold comparator 104 is configured to produce an output indicating an overvoltage event has occurred. In response to the voltage threshold comparator 104 producing an output indicating an overvoltage event has occurred, safety PMIC 100 is configured to disable voltage regulator 102 such that voltage regulator 102 no longer provides a voltage, output a signal indicating the overvoltage event for diagnostic purposes, or both.

To help ensure the reliable operation of voltage threshold comparator 104, safety PMIC 100 includes safety logic circuitry 108 configured to detect one or more latent faults in the configuration or operation of voltage threshold comparator 104. Such safety logic circuitry 108, for example, includes a digital circuitry having one or more microcontrollers, programmable logic devices, storages (e.g. programmable read-only memories (PROMs), electronically erasable read-only memories (EEPROMs), flash memories, solid-sate memories), or any combination thereof. In embodiments, based on at least a portion of the system powering up, such as one or more processors, safety logic circuitry 108 is configured to output a safety state control signal 118 that places the portion of the system into a safety state that disables normal operation of the portion of the system. While the portion of the system is in the safety state, LBIST circuitry 124, included with or otherwise connected to safety logic circuitry 108, performs an LBIST for safety logic circuitry 108. LBIST circuitry 124, for example, includes a digital circuitry having one or more microcontrollers, programmable logic devices, storages 116 (e.g. PROMs, EEPROMs, flash memories, solid-sate memories), or any combination thereof. During the LBIST, LBIST circuitry 124 is configured to check safety logic circuitry 108 for one or more latent faults. For example, LBIST circuitry 124 is configured to test data error protection operations 114, storages 116, one or more components of safety logic circuitry 108 (e.g., logic gates, microprocessors), or any combination thereof under one or more conditions to determine whether check safety logic circuitry 108 includes one or more latent faults.

After LBIST circuitry 124, based on the LBIST, determines that safety logic circuitry 108 does not include one or more latent faults (e.g., based on completion of the LBIST), safety logic circuitry 108 is configured to load safety configuration data 112 into a storage 116 from memory 106. Memory 106 includes a non-volatile memory, hard disk drive, solid-state drive, flash memory, random-access memory, or the like included in or otherwise connected to safety PMIC 100. The safety configuration data 112, for example, indicates one or more parameters for the voltage threshold comparator 104 such as values for a reference voltage to be supplied to voltage threshold comparator 104, a first supply voltage to apply to a first terminal of voltage threshold comparator 104, a second supply voltage to apply to a second terminal of voltage threshold comparator 104, impedances of voltage threshold comparator 104, or any combination thereof. After loading safety configuration data 112 in a storage 116, safety logic circuitry 108 implements one or more data error protection operations 114 such as one or more EECs, CRCs, or both to validate the safety configuration data 112, correct the safety configuration data 112, or both. As an example, safety logic circuitry 108 implements a data error protection operation 114 that includes a 16-bit CRC to validate the safety configuration data 112. Based on the data error protection operations 114 determining the safety configuration data 112 is invalid, not being able to correct the safety configuration data 112, or both, safety logic circuitry 108 outputs a signal (not shown for clarity) indicating that the safety configuration data 112 is invalid for diagnostic purposes. Based on the data error protection operations 114 determining the safety configuration data 112 is valid, being able to correct the safety configuration data 112, or both, safety logic circuitry 108 is configured to provide signals to voltage threshold comparator 104 based on the validated safety configuration data 112 (e.g., based on configuration data). For example, safety logic circuitry 108 provides a reference voltage to voltage threshold comparator 104, provides a first supply voltage to voltage threshold comparator 104, provides a second supply voltage to voltage threshold comparator 104, adjusts one or more impedance of voltage threshold comparator 104, or any combination thereof according to the values indicated in the validated safety configuration data 112.

After safety logic circuitry 108 provides signals to voltage threshold comparator 104 based on the validated safety configuration data 112, safety logic circuitry 108 is configured to begin powering up at least a portion of safety PMIC 100 such as one or more microcontrollers, storages 116, capacitors, or the like. As an example, safety logic circuitry 108 is configured to provide a regulator control signal 120 to voltage regulator 102 that is configured to enable voltage regulator 102 such that voltage regulator 102 outputs a voltage (e.g., non-zero voltage) or to disable voltage regulator 102 such that voltage regulator 102 does not output a voltage. For example, based on regulator control signal 120 including a first value, voltage regulator 102 is configured to be enabled and provide a voltage. Further, based on regulator control signal 120 including a second value different from the first value, voltage regulator 102 is configured to be disabled and not provide a voltage. To power up at least a portion of safety PMIC 100, safety logic circuitry 108 is configured to provide a regulator control signal 120 to voltage regulator 102 that enables voltage regulator 102 (e.g., a regulator control signal 120 having a first value). After at least a portion of safety PMIC 100 has been powered up, safety logic circuitry 108 is configured to perform an ABIST 110 to detect one or more latent faults of the voltage threshold comparator 104. Safety logic circuitry 108 is configured to perform the ABIST 110 by placing the voltage regulator 102, voltage threshold comparator 104, or both under certain conditions so as to induce corresponding events such as overvoltage events. Based on the range monitoring 122 performed by voltage threshold comparator 104 during these induced events, safety logic circuitry 108 determines whether the voltage threshold comparator 104 includes one or more latent faults. For example, safety logic circuitry 108 determines whether the voltage threshold comparator 104 outputs a signal indicating whether an induced event was detected. Based on whether an induced event was detected, safety logic circuitry 108 determines whether the voltage threshold comparator 104 includes one or more latent faults. Based on determining that the voltage threshold comparator 104 does not include any latent faults, the safety logic circuitry 108 updates safety state control signal 118 such that the portion of the system (e.g., a processor) is released from the safety state and is to begin normal operation. For example, the safety logic circuitry 108 updates safety state control signal 118 to include a value that releases the portion of the system from the safety state.

According to embodiments, safety PMIC 100 is configured to help reduce the time needed to release the portion of the system from the safety state by performing the LBIST concurrently with powering up at least a portion of the safety PMIC 100. For example, in embodiments, safety PMIC 100 includes a safety configuration circuitry separate and distinct from LBIST circuitry 124 that loads the safety configuration data 112 from memory 106, provides signals to voltage threshold comparator 104 based on the loaded safety configuration data 112, and enables voltage regulator 102 such that at least a portion of safety PMIC 100 begins powering up. Concurrently with the portion of safety PMIC 100 powering up, LBIST circuitry 124 is configured to perform the LBIST to help ensure safety logic circuitry 108 does not include a latent fault which allows safety logic circuitry 108 to validate the safety configuration data 112. As an example, concurrently with at least a portion of safety PMIC 100 powering up, LBIST circuitry 124 performs an LBIST to test for one or more latent faults in safety logic circuitry 108. Based on no latent faults being detected, safety logic circuitry 108 then validates the safety configuration data 112 and performs the ABIST 110. Because at least a portion of the LBIST is performed concurrently with powering up the portion of safety PMIC 100, the amount of time needed before the ABIST 110 can be performed is reduced which reduces the overall time needed to release the portion of the system from the safety state. Due to the safety state being released earlier, the portion of the system is enabled to more quickly begin normal operation (e.g., enabled to more quickly start-up), improving user experience.

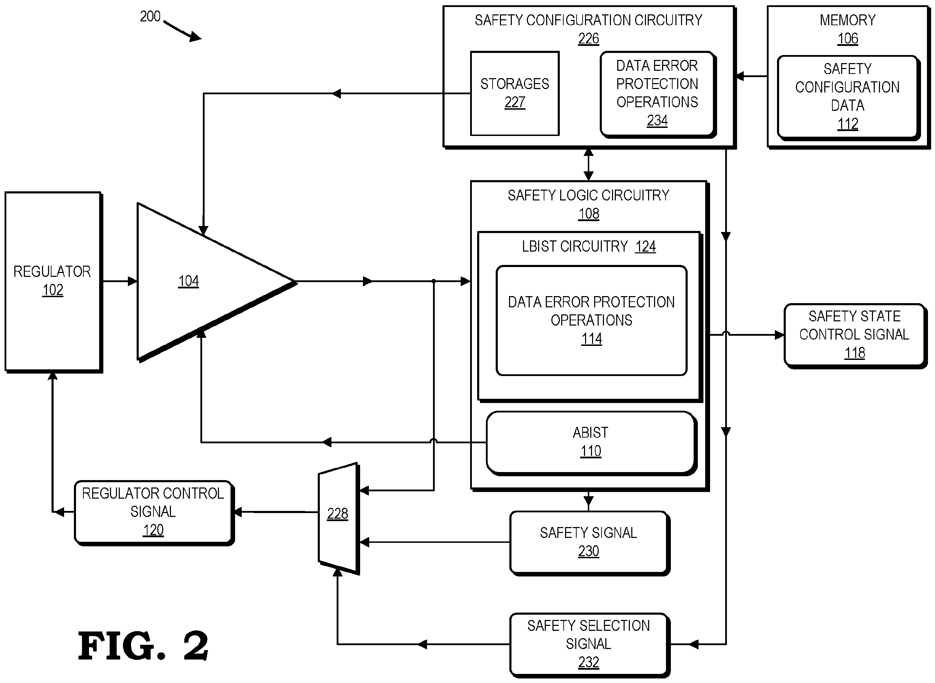

Referring now to FIG. 2, a safety PMIC architecture 200 for performing at least a portion of an LBIST concurrently powering up at least a portion of a safety PMIC is presented, in accordance with some embodiments. In embodiments, safety PMIC architecture 200 is implemented within safety PMIC 100. Safety PMIC architecture 200 includes voltage threshold comparator 104, safety configuration circuitry 226, safety logic circuitry 108, LBIST circuitry 124, and selector 228. According to embodiments, based on at least a portion of a system powering on (e.g., a system including safety PMIC 100), safety configuration circuitry 226 is configured to load safety configuration data 112 from memory 106 included in or otherwise connected to safety PMIC architecture 200. Safety configuration circuitry 226 includes, for example, one or more microcontrollers, programmable logic devices, storages (e.g. PROMs, EEPROMs, flash memories, solid-sate memories), or any combination thereof. As an example, safety configuration circuitry 226 loads safety configuration data 112 from memory 106 into a storage 227, similar to or the same as storage 116, of safety configuration circuitry 226. After loading safety configuration data 112, safety configuration circuitry 226 then implements one or more data error protection operations 234 to validate the loaded safety configuration data 112. These data error protection operations 234, for example, include one or more ECCs, CRCs, or both. In some embodiments, one or more data error protection operations 234 implemented by safety configuration circuitry 226 are different from each of the data error protection operations 114 implemented by safety logic circuitry 108. As an example, according to embodiments, data error protection operations 234 include an 8-bit CRC, and data error protection operations 114 include a 16-bit CRC. As another example, data error protection operations 234 includes one or more ECCs, CRCs, or both configured to be performed more quickly than the ECCs, CRCs, or both included in data error protection operations 114.

Based on determining that the loaded safety configuration data 112 is valid, safety configuration circuitry 226 configures voltage threshold comparator 104 by providing signals to voltage threshold comparator 104 based on the validated safety configuration data 112. For example, safety configuration circuitry 226 provides a reference voltage to voltage threshold comparator 104, provides a first supply voltage to voltage threshold comparator 104, provides a second supply voltage to voltage threshold comparator 104, adjusts one or more impedance of voltage threshold comparator 104, or any combination thereof based on corresponding values indicated in the validated safety configuration data 112. Further, after determining that the loaded safety configuration data 112 is valid, safety configuration circuitry 226 is configured to begin powering up at least a portion of safety PMIC 100 (e.g., one or more microcontrollers, storages, clocks, capacitors) by, for example, enabling voltage regulator 102 such that voltage regulator 102 begins to output a voltage. For example, within safety PMIC architecture 200, selector 228 includes a multiplexer configured to provide either an output of voltage threshold comparator 104 or a safety signal 230 from safety logic circuitry 108 as regulator control signal 120 (e.g., a signal that enables or disables voltage regulator 102). Further, selector 228 is configured to output (e.g., select between) an output of voltage threshold comparator 104 or a safety signal 230 from safety logic circuitry 108 based on safety selection signal 232 provided from safety configuration circuitry 226. As an example, based on safety selection signal 232 having a first value, selector 228 outputs the output from voltage threshold comparator 104 as regulator control signal 120. Additionally, based on safety selection signal 232 having a second value different from the first value, selector 228 outputs safety signal 230 from safety logic circuitry 108 as regulator control signal 120. According to embodiments, to begin powering up safety PMIC 100, safety configuration circuitry 226 provides a safety selection signal 232 to selector 228 that causes (e.g., that has a value that causes) selector 228 to output the output of voltage threshold comparator 104 as regulator control signal 120.

In response to receiving the output of voltage threshold comparator 104 as regulator control signal 120, voltage regulator 102 is configured to start providing a voltage to voltage threshold comparator 104 which begins to power up at least a portion of safety PMIC 100. Concurrently with the portion of safety PMIC 100 being powered up, LBIST circuitry 124 performs an LBIST to determine whether safety logic circuitry 108 includes one or more latent faults. For example, LBIST circuitry 124 is configured to test data error protection operations 114, one or more components of safety logic circuitry 108 (e.g., logic gates, microprocessors), or both under one or more conditions to determine whether check safety logic circuitry 108 includes one or more latent faults. Based on the LBIST indicating that safety logic circuitry 108 does not include a latent fault, safety logic circuitry 108 begins operation and loads safety configuration data 112 from the storage of safety configuration circuitry 226. Safety logic circuitry 108 then implements one or more data error protection operations 114 that include one or more ECCs, CRCs, or both different from one or more ECCs, CRCs, or both of data error protection operations 234 to validate the safety configuration data 112, correct errors in the safety configuration data 112, or both. Based on safety logic circuitry 108 determining the safety configuration data 112 is valid, correcting the safety configuration data 112 or both, safety logic circuitry 108 performs ABIST 110 to determine if voltage threshold comparator 104 includes any latent faults. In embodiments, because safety configuration data 112 is configured to perform LBIST concurrently with the safety PMIC 100 power-up, the time needed to power up the portion of safety PMIC 100 is reduced, allowing safety logic circuitry 108 to sooner perform ABIST 110. By sooner performing ABIST 110, the amount of time needed before the portion of the system may begin normal operation is reduced.

After performing the ABIST 110 and determining that voltage threshold comparator 104 does not contain one or more latent faults, safety logic circuitry 108 is configured to provide safety signal 230 as regulator control signal 120 to voltage regulator 102. Safety signal 230, for example, is configured to enable voltage regulator 102 such that voltage regulator 102 outputs a voltage based on voltage threshold comparator 104 not detecting an overvoltage event and disable voltage regulator 102 such that voltage regulator 102 does not output a voltage based on voltage threshold comparator 104 detecting an overvoltage event. For example, based on voltage threshold comparator 104 detecting an overvoltage event, safety logic circuitry 108 outputs a safety signal 230 having a first value that causes voltage regulator 102 to be disabled. Further, based on voltage threshold comparator 104 not detecting an overvoltage event, safety logic circuitry 108 outputs a safety signal 230 having a second value different from the first value that causes voltage regulator 102 to be enabled. To provide safety signal 230 to voltage regulator 102 as regulator control signal 120, safety configuration circuitry 226 is configured to output a safety selection signal 232 having a value that causes selector 228 to select safety signal 230 for output. After providing safety signal 230 as regulator control signal 120 to voltage regulator 102, safety logic circuitry 108 is configured to release the portion of the system from the safety state by updating safety state control signal 118. For example, safety logic circuitry 108 updates safety state control signal 118 to include a value that causes the portion of the system to begin normal operation.

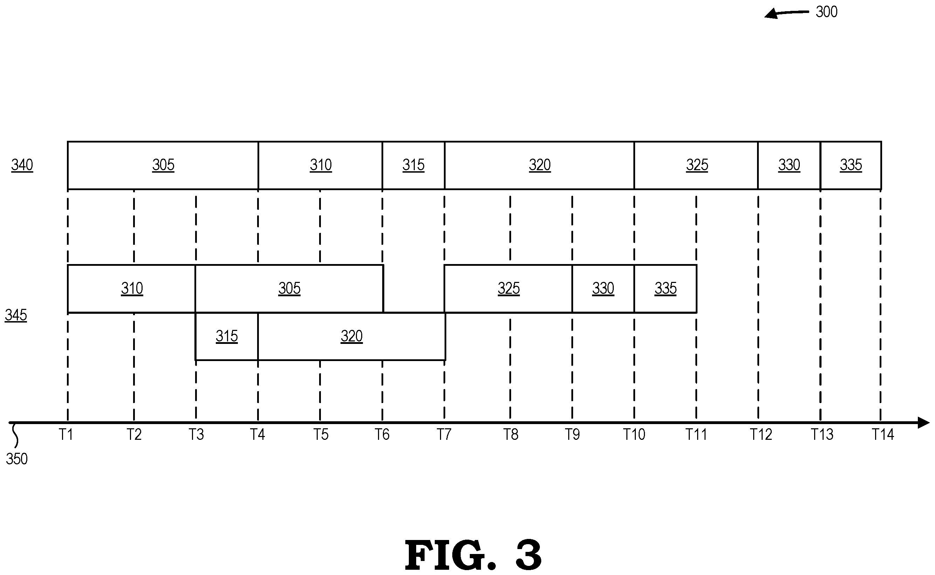

Referring now to FIG. 3, a timing diagram 300 for example safety start-up sequences 340, 345 is presented, in accordance with some embodiments. Timing diagram 300 includes an axis 350 representing time in microseconds, milliseconds, seconds, or the like and includes ticks representing example times (T1 to T14). In embodiments, safety start-up sequences 340, 345 are implemented at least in part by safety PMIC 100. During the first safety start-up sequence 340, at least a portion of safety PMIC 100 is configured to power up after completing an LBIST (e.g., configured to power up based on the completion of an LBIST). For example, between T1 and T3, block 305 of safety start-up sequence 340 includes LBIST circuitry 124 performing an LBIST to determine whether safety logic circuitry 108 includes one or more latent faults. At T4, LBIST circuitry 124 determines that safety logic circuitry 108 does not include a latent fault and begins block 310. Block 310, for example, includes safety logic circuitry 108 validating safety configuration data 112 and providing signals to voltage threshold comparator 104 based on the validated safety configuration data 112 (e.g., is configured based on the validated safety configuration data 112). After safety logic circuitry 108 is configured at T6, safety logic circuitry 108, at block 315, enables voltage regulator 102 such that voltage regulator 102 begins providing a voltage to voltage threshold comparator 104. At T7, at least a portion of safety PMIC 100 begins to power up, represented in FIG. 3 as block 320. At T10, after PMIC 100 has finished powering up, block 325 includes safety logic circuitry 108 performing ABIST 110 to determine if voltage threshold comparator 104 contains latent faults. At T12 after determining that voltage threshold comparator 104 does not contain one or more latent faults, block 330 includes safety logic circuitry 108 providing a safety signal (e.g., safety signal 230) to voltage regulator 102 that enables voltage regulator 102 when an overvoltage event is not detected and disables voltage regulator 102 when an overvoltage event is detected. After providing the safety signal to voltage regulator 102, at T13, block 335 includes safety logic circuitry 108 releasing at least a portion of a system from a safety state.

During the second safety start-up sequence 345, between T1 and T3, block 310 includes safety configuration circuitry 226 loading safety configuration data 112 from memory 106 and validating the safety configuration data 112 (e.g., via data error protection operations 234). Still referring to block 310, after validating the safety configuration data 112, safety configuration circuitry 226 configures voltage threshold comparator 104 based on the validated safety configuration data 112. At T3, block 305 includes LBIST circuitry 124 performing an LBIST to determine whether safety logic circuitry 108 includes one or more latent faults. After LBIST circuitry 124 has determined that safety logic circuitry 108 does not include one or more latent faults, safety configuration circuitry 108 validates the safety configuration data 112 loaded into safety configuration circuitry 226. For example, safety configuration circuitry 108 first loads the safety configuration data 112 and implements data error protection operations 114 to validate the safety configuration data 112. Further, at T3, concurrently with block 305, block 315 includes safety configuration circuitry 226 enabling voltage regulator 102 such that voltage regulator 102 outputs a voltage (e.g., a non-zero predetermined range of voltages) and at least a portion of safety PMIC 100 begins powering up. For example, safety configuration circuitry 226 provides a safety selection signal 232 that causes selector 228 to provide the output of voltage threshold comparator 104 to voltage regulator 102, enabling voltage regulator 102 to output a voltage such that at least a portion of safety PMIC 100 begins powering up.

At T4, concurrently with at least a portion of block 305, block 320 includes at least a portion of safety PMIC 100 powering up. After safety PMIC 100 has powered up, at T7, block 325 includes safety logic circuitry 108 performing ABIST 110 to determine if voltage threshold comparator 104 contains latent faults. At T9 after determining that voltage threshold comparator 104 does not contain one or more latent faults, block 330 includes safety logic circuitry 108 providing a safety signal (e.g., safety signal 230) to voltage regulator 102 that enables voltage regulator 102 when an overvoltage event is not detected and disables voltage regulator 102 when an overvoltage event is detected. After providing the safety signal to voltage regulator 102, at T10, block 335 includes safety logic circuitry 108 releasing at least a portion of a system from a safety state. As demonstrated by timing diagram 300, because, within safety start-up sequence 345, safety logic circuitry 108 performs, at block 305, LBIST concurrently with at least a portion of safety PMIC 100 powering up, at block 320, the time needed to release the portion of the system from the safety state is earlier (e.g., at T11) than compared to safety start-up sequence 340 (e.g., at T14) where the portion of the safety PMIC 100 is only powered-up after performing LBIST.

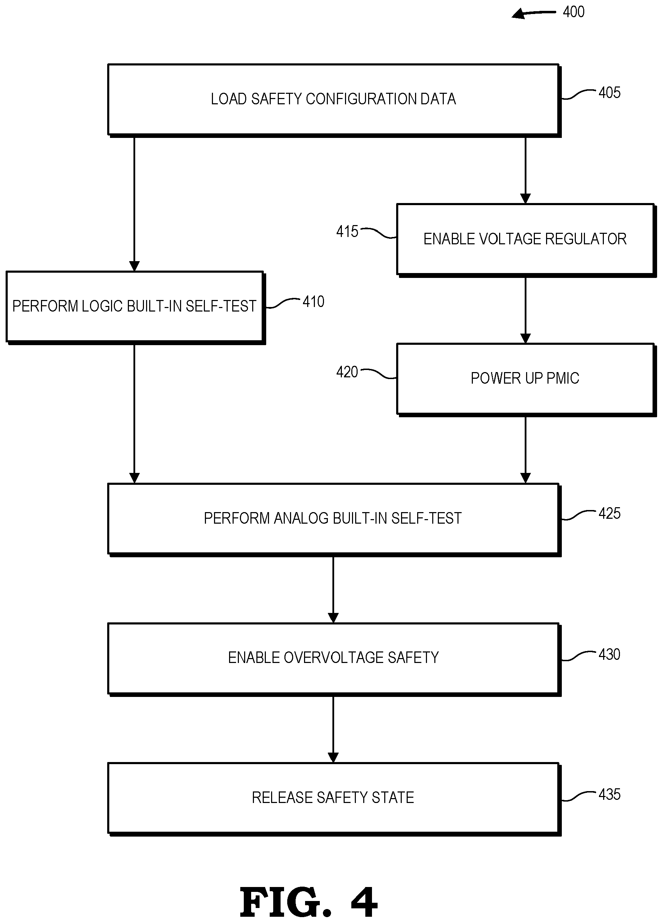

Referring now to FIG. 4, an example method 400 that includes performing at least a portion of an LBIST concurrently with powering up at least a portion of a safety PMIC is presented, in accordance with embodiments. In embodiments, example method 400 is performed at least in part by safety logic circuitry 108, safety configuration circuitry 226, or both. Based on a system beginning to power on, at block 405, safety configuration circuitry 226 is configured to load safety configuration data 112 from memory 106 into a storage of safety configuration circuitry 226. After loading the safety configuration data 112, safety configuration circuitry 226 validates the safety configuration data 112 by implementing one or more data error protection operations 114. For example, safety configuration circuitry 226 implements one or more ECCs, CRCs, or both to validate the safety configuration data 112, correct safety configuration data 112, or both. Still referring to block 305, after safety configuration data 112 is validated, safety configuration circuitry 226 configures voltage threshold comparator 104 based on the validated safety configuration data 112. For example, safety configuration circuitry 226 provides a reference voltage to voltage threshold comparator 104, provides a first supply voltage to voltage threshold comparator 104, provides a second supply voltage to voltage threshold comparator 104, adjusts one or more impedance of voltage threshold comparator 104, or any combination thereof based on corresponding values indicated in the validated safety configuration data 112.

At block 415, after configuring voltage threshold comparator 104, safety configuration circuitry 226 is configured to enable voltage regulator 102 such that voltage regulator 102 outputs a non-zero voltage (e.g., a predetermined range of voltages). For example, safety configuration circuitry 226 provides a safety selection signal 232 to selector 228 that causes selector 228 to provide the output of voltage threshold comparator 104 to voltage regulator 102. Based on receiving the output of voltage threshold comparator 104, voltage regulator 102 begins to output a non-zero voltage. After voltage regulator 102 begins outputting a non-zero voltage, at block 420, safety PMIC 100 begins to power up. For example, the voltage provided by voltage regulator 102 begins to power up one or more components of safety PMIC 100 such as one or more microcontrollers, storages, capacitors, clocks, or any combination thereof. Additionally, concurrently with at least a portion of block 415, block 420, or both, LBIST circuitry 124 is configured to perform an LBIST to determine whether safety logic circuitry 108 includes one or more latent faults. As an example, during the LBIST, LBIST circuitry 124 tests data error protection operations 114, one or more components of safety logic circuitry 108 (e.g., logic gates, microprocessors), or both under one or more conditions to determines whether check safety logic circuitry 108 includes one or more latent faults. Still referring to block 410, after LBIST circuitry 124 determines, based on the LBIST, that safety logic 108 does not include one or more latent faults, safety logic circuitry 108 loads safety configuration data 112 and validates safety configuration data 112 by implementing one or more data error protection operations 114 (e.g., one or more ECCs, CRCs, or both). Based on validating the safety configuration data 112, safety logic circuitry 108 then begins one or more operations (e.g., ABIST 110) based on the validated safety configuration data 112.

For example, referring now to block 425, after safety logic circuitry 108 has validated safety configuration data 112, at least a portion of safety PMIC 100 has been powered on, or both, safety logic circuitry 108 performs ABIST 110 to detect one or more latent faults in voltage threshold comparator 104. As an example, during ABIST 110, safety logic circuitry 108 places voltage regulator 102, voltage threshold comparator 104, or both under certain conditions so as to induce corresponding events such as overvoltage events. Based on the range monitoring 122 performed by voltage threshold comparator 104 during these induced events, safety logic circuitry 108 determines whether the voltage threshold comparator 104 includes one or more latent faults. After completing ABIST 110 (e.g., based on completion of ABIST 110) and determining that voltage threshold comparator 104 does not include one or more latent faults, at block 430, safety logic circuitry 108 is configured to enable overvoltage safety. That is, based on the completion of ABIST 110 and based on determining that voltage threshold comparator 104 does not include one or more latent faults, safety logic circuitry 108 is configured to enable overvoltage safety. For example, safety logic circuitry 108 is configured to provide a safety signal (e.g., safety signal 230) to voltage regulator 102 that enables voltage regulator 102 when an overvoltage event is not detected and disables voltage regulator 102 when an overvoltage event is detected. In embodiments, such a safety signal is provided to voltage regulator 102 based on a safety selection signal 232 output by safety configuration circuitry 226. At block 435, after safety logic circuitry 108 has enabled overvoltage protection, safety logic circuitry 108 releases at least a portion of a system from a safety state by, for example, updating safety state control signal 118.

In some embodiments, certain aspects of the techniques described above may implemented by one or more processors of a processing system executing software. The software comprises one or more sets of executable instructions stored or otherwise tangibly embodied on a non-transitory computer-readable storage medium. The software can include the instructions and certain data that, when executed by the one or more processors, manipulate the one or more processors to perform one or more aspects of the techniques described above. The non-transitory computer-readable storage medium can include, for example, a magnetic or optical disk storage device, solid-state storage devices such as Flash memory, a cache, random access memory (RAM) or other non-volatile memory device or devices, and the like. The executable instructions stored on the non-transitory computer-readable storage medium may be in source code, assembly language code, object code, or other instruction format that is interpreted or otherwise executable by one or more processors.

A computer-readable storage medium may include any storage medium, or combination of storage media, accessible by a computer system during use to provide instructions and/or data to the computer system. Such storage media can include but is not limited to, optical media (e.g., compact disc (CD), digital versatile disc (DVD), Blu-Ray disc), magnetic media (e.g., floppy disc, magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer-readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory), or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed is not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. An integrated circuit (IC), comprising:
a first digital circuitry configured to:
configure a voltage threshold comparator based on configuration data; and
based on the voltage threshold comparator being configured, enable a voltage regulator such that the voltage regulator outputs a voltage and at least a portion of the IC begins powering on; and
a second digital circuitry separate from the first digital circuitry and configured to:
concurrently with the at least a portion of the IC powering on, perform a logic built-in self-test (LBIST) for a third digital circuitry configured to monitor the voltage threshold comparator.

2. The IC of claim 1, wherein the third digital circuitry is configured to:
after completion of the LBIST, validate the configuration data based on one or more data error protection operations.

3. The IC of claim 2, wherein the first digital circuitry is configured to:
before configuring the voltage threshold comparator based on the configuration data, validate the configuration data based on a data error protection operation different from the one or more data error protection operations.

4. The IC of any preceding claim, wherein the third digital circuitry is configured to:
perform an analog built-in self-test (ABIST) to determine whether the voltage threshold comparator includes one or more latent faults.

5. The IC of claim 4, wherein the third digital circuitry is configured to:
release at least a portion of a system including the IC from a safety state based on completion of the ABIST.

6. The IC of claim 4 or 5, further comprising:
a multiplexer configured to:
based on the voltage threshold comparator being configured by the first digital circuitry, provide an output of the voltage threshold comparator to the voltage regulator; and
based on the ABIST being completed, provide a safety signal from the third digital circuitry to the voltage regulator.

7. The IC of claim 6, wherein the third digital circuitry is configured to:
in response to the voltage threshold comparator detecting an overvoltage event, disable, via the safety signal, the voltage regulator such that the voltage regulator does not provide the voltage.

8. The IC of any preceding claim, wherein the third digital circuitry is configured to:
based on the LBIST being completed, load the configuration data from the first digital circuitry.

9. A method, comprising:
configuring, by a first digital circuitry of an integrated circuit (IC), a voltage threshold comparator based on configuration data;
based on the voltage threshold comparator being configured, enabling a voltage regulator such that the voltage regulator outputs a voltage and at least a portion of the IC begins powering on; and
concurrently with the at least a portion of the IC powering on, performing a logic built-in self-test (LBIST) for a second digital circuitry configured to monitor the voltage threshold comparator.

10. The method of claim 9, further comprising:
after the LBIST, validating, by the second digital circuitry, the configuration data based on one or more data error protection operations.

11. The method of claim 10, further comprising:
before configuring the voltage threshold comparator based on the configuration data, validating, by the first digital circuitry, the configuration data based on a data error protection operation different from the one or more data error protection operations.

12. The method of any one of claims 9 to 11, further comprising:
performing, by the second digital circuitry, an analog built-in self-test (ABIST) to determine whether the voltage threshold comparator includes one or more latent faults.

13. The method of claim 12, further comprising:
releasing, by the second digital circuitry, at least a portion of a system including the IC from a safety state based on a completion of the ABIST.

14. The method of claim 12 or 13, further comprising:
based on the voltage threshold comparator being configured by the first digital circuitry, providing an output of the voltage threshold comparator to the voltage regulator; and
based on the ABIST being completed, providing a safety signal from the second digital circuitry to the voltage regulator.

15. The method of claim 14, further comprising:
in response to the voltage threshold comparator detecting an overvoltage event, disabling, via the safety signal, the voltage regulator such that the voltage regulator does not provide the voltage.

## Amended claims

### Amended claims in accordance with Rule 137(2) EPC.

1. An integrated circuit, IC, (100; 200) comprising:
a first digital circuitry (226) configured to:
load safety configuration data (112) from memory (106) of the IC (100; 200);
configure a voltage threshold comparator (104) based on the safety configuration data (112); and
based on the voltage threshold comparator (104) being configured, enable a voltage regulator (102) such that the voltage regulator (102) outputs a voltage and at least a portion of the IC (100; 200) begins powering on; and
a second digital circuitry (124) separate from the first digital circuitry (226) and configured to:
concurrently with the at least a portion of the IC (100; 200) powering on, perform a logic built-in self-test,LBIST, for a third digital circuitry (108); wherein the third digital circuitry (108) is configured to monitor the voltage threshold comparator (104).

2. The IC (100; 200) of claim 1, wherein the third digital circuitry (108) is configured to:
after completion of the LBIST, validate the configuration data (112) based on one or more data error protection operations (114).

3. The IC (100; 200) of claim 2, wherein the first digital circuitry (226) is configured to:
before configuring the voltage threshold comparator (104) based on the configuration data (112), validate the configuration data (112) based on a data error protection operation different from the one or more data error protection operations.

4. The IC (100; 200) of any preceding claim, wherein the third digital circuitry (108) is configured to:
perform an analog built-in self-test,ABIST, to determine whether the voltage threshold comparator (104) includes one or more latent faults.

5. The IC (100; 200) of claim 4, wherein the third digital circuitry (108) is configured to:
release at least a portion of a system including the IC (100; 200) from a safety state based on completion of the ABIST.

6. The IC (100; 200) of claim 4 or 5, further comprising:
a multiplexer configured to:
based on the voltage threshold comparator (104) being configured by the first digital circuitry (226), provide an output of the voltage threshold comparator (104) to the voltage regulator (102); and
based on the ABIST being completed, provide a safety signal (120) from the third digital circuitry (108) to the voltage regulator (102).

7. The IC (100; 200) of claim 6, wherein the third digital circuitry (108) is configured to:
in response to the voltage threshold comparator (104) detecting an overvoltage event, disable, via the safety signal (120), the voltage regulator (102) such that the voltage regulator (102)does not provide the voltage.

8. The IC (100; 200) of any preceding claim, wherein the third digital circuitry (108) is configured to:
based on the LBIST being completed, load the configuration data (112) from the first digital circuitry (226).

9. A method, comprising:
loading, by a first digital circuitry (226), safety configuration data (112) from memory (106) of an integrated circuit, IC, (100; 200);
configuring, by the first digital circuitry (226) of the IC, (100; 200) a voltage threshold comparator (104) based on the safety configuration data (112);
based on the voltage threshold comparator (104) being configured, enabling a voltage regulator (102) such that the voltage regulator (102) outputs a voltage and at least a portion of the IC (100; 200) begins powering on; and
concurrently with the at least a portion of the IC (100; 200) powering on, performing a logic built-in self-test,LBIST, by a second digital circuitry (108) for a third digital circuitry (108), wherein the third digital circuitry (108) is configured to monitor the voltage threshold comparator (104).

10. The method of claim 9, further comprising:
after the LBIST, validating, by the second digital circuitry (124), the configuration data (112) based on one or more data error protection operations.

11. The method of claim 10, further comprising:
before configuring the voltage threshold comparator (104) based on the configuration data (112), validating, by the first digital circuitry (226), the configuration data (112) based on a data error protection operation different from the one or more data error protection operations.

12. The method of any one of claims 9 to 11, further comprising:
performing, by the second digital circuitry (124), an analog built-in self-test, ABIST, to determine whether the voltage threshold comparator (104) includes one or more latent faults.

13. The method of claim 12, further comprising:
releasing, by the second digital circuitry (124), at least a portion of a system including the IC (100; 200) from a safety state based on a completion of the ABIST.

14. The method of claim 12 or 13, further comprising:
based on the voltage threshold comparator (104) being configured by the first digital circuitry (226), providing an output of the voltage threshold comparator (104) to the voltage regulator (102); and
based on the ABIST being completed, providing a safety signal (120) from the second digital circuitry (124) to the voltage regulator (102).

15. The method of claim 14, further comprising:
in response to the voltage threshold comparator (104) detecting an overvoltage event, disabling, via the safety signal, the voltage regulator (102) such that the voltage regulator (102) does not provide the voltage.
